(19)

Europäisches
Patentamt
European
Patent Office
Office européen
des brevets

(11) **EP 3 782 056 B1**

(12) **EUROPEAN PATENT SPECIFICATION**

(45) Date of publication and mention
of the grant of the patent:
**22.11.2023 Bulletin 2023/47**

(21) Application number: **19721963.7**

(22) Date of filing: **19.04.2019**

(51) International Patent Classification (IPC):
**G06F 30/13** $^{(2020.01)}$

(52) Cooperative Patent Classification (CPC):
**G06F 30/13**

(86) International application number:
**PCT/US2019/028264**

(87) International publication number:
**WO 2019/204691 (24.10.2019 Gazette 2019/43)**

(54) **SYSTEM AND METHOD FOR CLINICAL LABORATORY LAYOUT DESIGN**

SYSTEM UND VERFAHREN ZUM ENTWURF EINER KLINISCHEN LABORANORDNUNG

SYSTÈME ET PROCÉDÉ DE CONCEPTION D'AGENCEMENT DE LABORATOIRE CLINIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.04.2018 US 201862660461 P**

(43) Date of publication of application:
**24.02.2021 Bulletin 2021/08**

(73) Proprietor: **Beckman Coulter, Inc.
Brea, CA 92821 (US)**

(72) Inventors:
• **VARLET, Eric**
**59790 Ronchin (FR)**
• **FARAMARZI OGHANI, Sohrab**
**59650 Villeneue d'Ascq (FR)**
• **TALBI, Ei Ghazali**
**59000 Lille (FR)**
• **BUÉ, Martin**
**59000 Lille (FR)**

(74) Representative: **Maiwald GmbH
Elisenhof
Elisenstraße 3
80335 München (DE)**

(56) References cited:
• **C. ABDELAHAD ET AL: "A mixed integer
programming formulation for solving operating
theatre layout problem: A multi-goal approach",
PROCEEDINGS OF THE 5TH INTERNATIONAL
CONFERENCE ON INDUSTRIAL ENGINEERING
AND SYSTEMS MANAGEMENT (IESM) - I4E2, 28
October 2013 (2013-10-28), pages 1-10,
XP032578078, [retrieved on 2014-03-07]**
• **S. P. SINGH ET AL: "A review of different
approaches to the facility layout problems", THE
INTERNATIONAL JOURNAL OF ADVANCED
MANUFACTURING TECHNOLOGY, vol. 30, no.
5-6, 12 November 2005 (2005-11-12), pages
425-433, XP019419080, ISSN: 1433-3015, DOI:
10.1007/S00170-005-0087-9**

## Description

FIELD

The disclosed technology pertains to a system and method for heuristically generating the layout of a laboratory.

BACKGROUND

Standalone clinical laboratories may comprise of a number of facilities (herein used to refer to workstations, machines, instruments, workbenches, and other equipment), such as workstations, machines, instruments, workbenches, and computer consoles. Efficient physical placement of such facilities in a standalone clinical laboratory can improve the efficiency and productivity of the laboratory, such as by reducing walking time and distance for operators. This concept is generally referred to as the Facility Layout Problem ("FLP"). One difficulty with FLP is that it is a complex problem that is NP-hard, meaning that exact algorithms or static approaches that attempt to systematically evaluate or solve for every possible layout in order to find one truly optimal layout are extremely inefficient if not entirely impossible for medium and large-scale layouts having a variety of facilities. For example, in a simple hypothetical lab with just ten different equally sized facilities, and ten different equally sized facility install locations, the number of possible arrangements nears four million. Large-scale facilities might have 50 or more facilities of different shapes and sizes, and hundreds of potential install locations for each facility. Such variability quickly becomes unrealistic to solve with a brute force approach.

C. ABDELAHAD ET AL: "A mixed integer programming formulation for solving operating theatre layout problem: A multi-goal approach" and

S. P. SINGH ET AL: "A review of different approaches to the facility layout problems" are important prior art documents.

SUMMARY

There is a need for an improved system and method for programmatically generating efficient laboratory layouts. There is a need for improved technology for producing solutions to the facility layout problem, in light of one or more constraints within a laboratory environment. It may thus be an object of some embodiments to provide a method that could comprise steps such as obtaining a set of constraints pertaining to a set of facilities and a laboratory area; obtaining a flow collection that describes one or more flows of objects between facilities from the set of facilities; and using a heuristic algorithm, generating a set of initial layouts for the facilities within the laboratory area based upon a set of partial layouts, the flow collection and the set of constraints. In some embodiments, this objective may be fulfilled by the subject matter of the independent claims, wherein further embodiments are incorporated in the dependent claims.

BRIEF DESCRIPTION OF THE DRAWINGS

The drawings and detailed description that follow are intended to be merely illustrative and are not intended to limit the scope of the invention as contemplated by the inventors.

FIG. 1 is a flowchart of an exemplary set of high-level steps that a system could perform to generate an efficient laboratory layout;

FIG. 2 is a flowchart of an exemplary set of steps that a system could perform to sort facilities before placement;

FIG. 3 is a flowchart of an exemplary set of steps that a system could perform to place facilities and generate a set of initial solutions;

FIG. 4 is a flowchart of an exemplary set of steps that a system could perform to produce a larger set of initial solutions using a set of partial solutions;

FIG. 5 is a flowchart of an exemplary set of steps that a system could perform to select a set of diverse solutions from the set of initial solutions;

FIG. 6 is a flowchart of an exemplary set of steps that a system could perform to improve the selected set of diverse solutions;

FIG. 7 is a diagram of an exemplary laboratory area;

FIG. 8 is a diagram of the exemplary laboratory area sectioned into a grid; and

FIG. 9 is a diagram of the exemplary laboratory area with a set of facilities placed by a system performing the steps of FIG. 1.

DETAILED DESCRIPTION

In light of the above, it could be beneficial to test and generate solutions for the FLP heuristically so that high quality solutions can be quickly generated. According to a first aspect, some embodiments may include a method comprising steps such as obtaining a set of constraints pertaining to a set of facilities and a laboratory area; obtaining a flow collection that describes one or more flows of objects between facilities from the set of facilities; and using a heuristic algorithm, generating a set of initial layouts for the facilities within the laboratory area based upon a set of partial layouts, the flow collection and the set of constraints.

In some embodiments, such as described in the context of the first aspect, the set of constraints comprises, for each facility: a dimension of the facility (which may be a rectangular dimension); and a discipline; the laboratory area comprises: a dimension (which may be a rectangular dimension); a set of free areas; and an entrance.

In some embodiments, such as described in the context of the preceding paragraph, the aspect further comprises steps such as identifying a set of diverse layouts within the set of initial layouts using a diversity measure algorithm, wherein: each layout in the set of initial layouts comprises a set of discipline groups; a best initial layout in the set of initial layouts is immediately added to the set of diverse layouts; and the diversity measure algorithm comprises, for each layout in the set of initial layouts, determining a sum of distances between gravity centers of each of the sets of discipline groups in that layout, and, where the sum of distances for that layout is substantially different from the sum of distances of each diverse layout in the set of diverse layouts, add that layout to the set of diverse layouts.

In some embodiments, such as described in the context of the preceding paragraph, each diverse layout of the set of diverse layouts comprises a set of facility placements, the method further comprising the step of improving the set of diverse layouts by: building an adjacency graph for each diverse layout of the set of diverse layouts; for each facility placement of the set of facility placements for each diverse layout, swapping that facility placement with another facility placement of the same dimension to create a test layout; modifying the adjacency graph for the test layout; verifying that a discipline adjacency constraint is valid for the test layout using the adjacency graph; and only where the score of the test layout improves relative to that diverse layout, and the adjacency constraint is valid for the test layout, replace that diverse layout with the test layout.

In some embodiments, such as described in the context of any of the four preceding paragraphs, the step of generating the set of initial layouts comprises sorting the set of facilities into a sorted facility list by: adding a registration facility of the set of facilities at a first position of the sorted facility list; and for each remaining facility of the set of facilities, repeating the steps of: selecting, as a selected facility, a facility from the set of facilities that has the highest flow with a most recently added facility based upon the flow collection; where there is no facility sharing flow with the most recently added facility, selecting, as the selected facility, a facility from the set of facilities that has the highest total closeness rating, where total closeness rating can be determined as the sum of input flow and output flow for the facility based upon the flow collection; and adding the selected facility to a next position in the sorted facility list.

In some embodiments, such as described in the context of preceding paragraph, the step of generating the set of initial layouts comprises placing the facilities by: selecting the registration facility from the first position of the sorted list and placing it by an entrance of the laboratory; for each remaining facility of the sorted facility list, repeating the steps of: selecting that facility from the sorted facility list; creating the set of partial layouts based on a set of possible placements for that facility; scoring each of the set of partial layouts using an objective equation; using a branch and bound algorithm, extending each of the set of partial layouts until either a final layout is reached for that partial layout, or one or more stop criteria are satisfied for that partial layout; and only where the final layout is reached, adding that partial layout to the set of initial layouts.

In some embodiments, such as described in the context of the preceding paragraph, the one or more stop criteria comprises: a first criteria satisfied when a score for that partial layout is worse than a score for a second partial layout of the set of partial layouts, wherein the second partial layout has more of the set of facilities placed than that partial layout; and a second criteria satisfied when placement of a subsequent facility is impossible.

In some embodiments, such as described in the context of the preceding paragraph, the set of possible placements for that facility comprises both a facility placement location and a facility placement orientation, and wherein the facility placement orientation consists of a vertical orientation and a horizontal orientation.

In some embodiments, such as described in the context of any of the eight preceding paragraphs, the set of facilities and the laboratory area are rectangular and discretized to a scale measurement.

In some embodiments, there may be provided a method implemented on a device comprising obtaining a set of constraints pertaining to a set of facilities and a laboratory area. Such a method may also include obtaining a flow collection that describes one or more flows of objects between facilities from the set of facilities. Such a method may also comprise, using a heuristic algorithm, generating a set of initial layouts for facilities within the laboratory area based upon a set of partial layouts, the flow collection and the set of constraints. In such an embodiment, the set of constraints may comprise, for each facility, a dimension (which may be a rectangular dimension) and a discipline. In such an embodiment, the laboratory area may comprise a dimension (which may be a rectangular dimension), a set of free areas, and an entrance. In some such embodiments, the heuristic algorithm may enforce an adjacency constraint that requires each facility of the set of facilities in the layout to be positioned in the layout so that the discipline of that facility is the same as the discipline of at least one adjacent facility, unless that facility is the only facility having the discipline.

Corresponding systems comprising one or more computers configured by computer executable instructions stored on non-transitory computer readable media to perform steps of methods described in any of the preceding embodiments, as well as non-transitory computer readable media storing instructions for performing steps of method described in any of the preceding embodiments, could also be implemented without undue experimentation by those of ordinary skill in the art based on this disclosure. Accordingly, the preceding description of potential embodiments and aspects should be understood as being illustrative only, and should not be treated as limiting.

Some embodiments of the disclosed technology may use a heuristic approach to ideally generate an optimal or near-optimal solution to the FLP by generating a manageable set of possible solutions, improving upon those solutions if possible, and then selecting the best remaining solution as the facility layout. Generally, the FLP deals with the physical arrangement of facilities within an area. Physical arrangement of facilities comprises the specification of a location, and an orientation (e.g., vertical, horizontal, diagonal, and or/other types of rotations) of each facility to optimize one or more objectives that are required or valued within a laboratory. One of the main goals for solving the FLP of a laboratory such as a standalone clinical laboratory may be defined as specifying the location and orientation of each instrument within the laboratory in order to minimize the total traveling distance, while still satisfying physical, technical, and organizational constraints.

When approaching the FLP, it may help to provide some static assumptions that may be made relating to the laboratory and facilities involved in a certain FLP. This is not a requirement, and various implementations of this technology may rely on all of these assumptions, none of the assumptions, or somewhere in between.

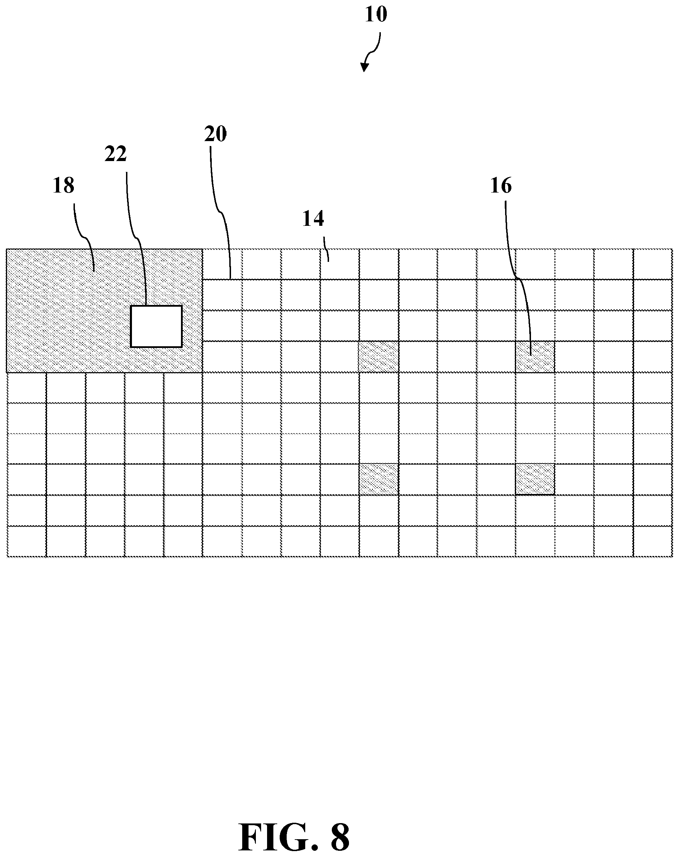

One assumption that may be made for the laboratory area is that the laboratory area is a single-floor space where facilities may be arranged. In some embodiments, this area may be given and can have any shape including simple and complex polygons. The actual shape of the laboratory area may be created by starting with a rectangle, and then removing additional locations within the rectangle in order to obtain the actual shape. FIG. 8 shows a laboratory area 10 that follows this assumption. The laboratory area 10 has an initial rectangular shape, and an area has been removed to account for an unavailable area 18 such as lobby, restroom, waiting area, or other location where a facility may not be placed. The remaining free area 14 is sectioned into a gridwork 20 of equally sized areas.

Another assumption that may be made for the laboratory area is that the position of one or more occupied areas 16 within the laboratory boundaries is known. This could include structural pillars, pre-located facilities with fixed positions, safety features or devices that are immovable, and other types of occupying objects.

Another assumption that may be made for the laboratory area is that there is an entrance 22 where all test tubes, test materials, test samples, and other testable objects enter the laboratory, and the location of the entrance 22 is known. The entrance may be anywhere along the boundary of the laboratory area 10, or even in the middle, such as where an elevator, stair, ladder, pneumatic delivery device, or other structure or device allows for samples to arrive in the middle of the room, rather than through a peripheral door.

One assumption that may be made for facilities that will be placed in the laboratory is that they have known, rectangular dimensions. As with the laboratory area itself, each facility can be discretized into a rectangular shape and based on the discretization scale so that a facility may occupy one or more free areas 14 in the laboratory area 10. Additionally, in some embodiments, as with the laboratory itself, a rectangular dimension of a facility may have areas removed from an initial rectangular dimension to more accurately represent shapes of facilities that are not rectangular. Once placed in one or more free areas 14 of the laboratory area 10, a cell (which, in some embodiments, may be a free area cell and in some embodiments may be a cell occupied by the facility, or a cell in a facility's clearance area) can be considered the connection point of that facility with other facilities (referred to herein as the centroid of the facility).

Another assumption that may be made for facilities is that the clearance within and around a facility that is required for operators to easily use the facility is known for each facility, and is included in the dimensions of that facility, though in some embodiments this type of assumption may be relaxed. For example, in some embodiments required clearance around a facility may be added to the dimensions of that facility, rather than being assumed to be included in the dimensions of a facility.

Another assumption that may be made for facilities is that the orientation of the facility is not known and is instead determined by the algorithm, and that the possible orientations for a facility are either vertical, or horizontal.

Another assumption that may be made in some embodiments for facilities is that each facility is known to be associated with a discipline. When there are two or more facilities associated with a particular discipline, each facility associated with that discipline must be placed in the laboratory area 10 so that it is adjacent to at least one other facility that is also associated with that discipline or with a similar discipline. In some embodiments, this may be done, for example, by using data structures representing individual facilities that comprise information indicating those facilities' disciplines, and maintaining a translation table indicating which disciplines should be considered "similar" for the purposes of facility placement.

Another assumption that may be made for facilities is that distance between the centroids of any two facilities is a rectilinear, or Manhattan, distance (i.e., movement conforming to the lines of the gridwork 20), as this approximates realistic movement of staff and other personnel within and between facilities inside the laboratory. Rectilinear distance can be computed for two points, p(x,y) and p'(x',y') as $|x - x'| + |y - y'|$.

Another assumption that may be made for facilities is that the relationship between each pair of facilities is stored in and demonstrated by a flow collection or other quantitative asymmetric data structure such as a multidimensional set, list, array, or matrix (e.g., an asymmetric flow matrix). The values used for this flow collection may vary by implementation, but as one example, could present the average number of tubes transported from one point to another, the average number of times that an operator travels between two points, or other similar values.

Similar to assumptions of characteristics of the facilities and laboratory area, it may also benefit some embodiments to define constraints that a solution (e.g., a layout of facilities) must adhere to, or characteristics that the solution must present. For example, these constraints could include physical constraints, technical constraints, and organization constraints. Physical constraints could include that no facility may overlap another facility, an unavailable area 18, or an occupied area 16. Technical constraints could include the known clearances that are required for each facility, and added to that facility's total dimensions, also respect and meet minimum technical and safety requirements for the laboratory area 10, the facility itself, or both. Organizational constraints may include the requirement that, where there are two or more facilities of a particular discipline, each facility of that discipline must be placed so that it is adjacent to another facility of that or a similar discipline. This organizational constraint may also be referred to as an adjacency constraint or requirement. While some constraints may be common for layout problems generally, the adjacency constraint originates more specifically from the generation of solutions to the FLP for clinical laboratory organization.

Finally, before discussing the heuristic process itself, it may be helpful to define a manner in which, in some embodiments, solutions may be measured in terms of meeting the objective of arranging all facilities within the laboratory area in a way that total traveling distance among facilities, based upon the flow collection data (e.g., vial traffic, operator traffic), is minimized. One exemplary equation for providing objective measurement of solutions for this FLP is:

$$\sum_{e \in E} \sum_{\substack{e' \in E \\ e' \neq e}} f(e, e') * d(c_e, c_{e'})$$

where E is a set of facilities, e and e' denote the facilities as the members of E, $c_e$ and $c_{e'}$ imply the centroids of the facilities e and e' respectively, parameter f(e,e') denotes the flow between the facility pair (e, e'), and parameter $d(c_e, c_{e'})$ denotes the distance between the centroids of the facility pair $(c_e, c_{e'})$.

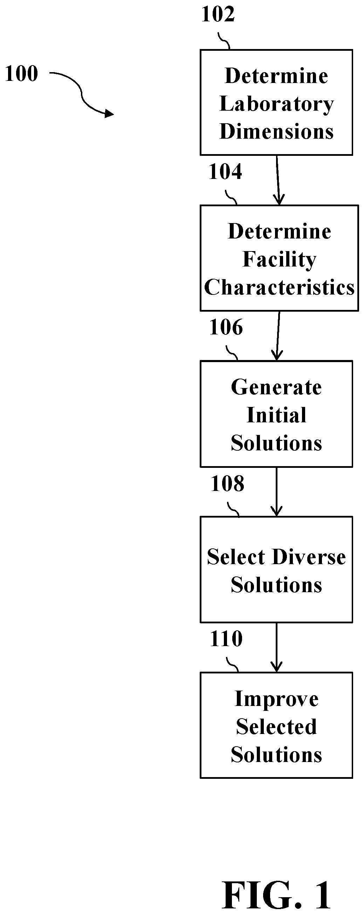

Turning now to FIG. 1, that figure shows a flowchart of an exemplary set of high-level steps 100 that a system could perform to generate an efficient laboratory layout. A system configured to perform the steps of FIG.

1 could be a computing device such as a physical server, virtual server, cloud server, parallel processing servers, or other computing device that has appropriate processing speed and data storage for a given implementation. For example, in an implementation for generating solutions to the FLP for small laboratories, a desktop computer or laptop configured with software to perform the steps of FIG. 1 may be sufficient. For large laboratories, one or more high performance servers working in parallel may be desirable.

Initially, some embodiments may determine 102 the laboratory dimensions and characteristics and determine 104 the facility dimensions and characteristics. This could include accessing a dataset describing the laboratory and a dataset describing the facilities it must support from a local disk or an accessible database, or accessing data that may be used to determine those datasets. It may also include having the appropriate dimensions and/or other information entered by a user through an interface, such as a graphical user interface. A dataset describing the laboratory dimensions could include the outer dimension of each wall of the laboratory area 10 (i.e., including the walls around the free space 14 but excluding the outer wall along the unavailable area 18), which areas of the laboratory area 10 are occupied areas 16, and a door location 22. Additionally, in some embodiments, determining laboratory dimensions 102 may comprise determining (e.g., through retrieval from a database, through receipt via an interface, or in other manners) appropriate units of measurement, sizes and/or shapes of the tessellation 20 that the laboratory area 10 would be divided into. A dataset describing the facilities could describe, for one or more facilities, a name and description of the facility, the discipline that the facility is associated with, the dimensions of the facility (e.g., its dimensions) including the clearance around the facility, and the flow collection values for the facility or data that could be used to generate the flow collection values for the facility.

Having determined 102 104 the laboratory dimensions and facility characteristics, in some embodiments, a system implementing a method such as shown in figure 1 may heuristically generate 106 a set of initial solutions for the FLP. The set of initial solutions for the FLP may contain one or more solutions (e.g., specifications of locations and orientations of each facility within the laboratory area 10) that each allow each facility to be placed within the laboratory area, while complying with relevant constraints and assumptions. In some embodiments, this type of initial solution generation 106 may be performed in a two step process, in which facilities are initially sorted (e.g., by importance, constraint level, etc.) and are then placed in the order of their sorting.

The set of initial solutions may in some instances contain a large number of solutions, with subsets within that large number containing a number of very similar solutions. For example, in some instances, a set of 10 initial solutions may contain three truly diverse solutions, and seven other solutions that are just minor or insignificant variations on one of the three diverse solutions. To improve the quality of final solutions that are offered, in some embodiments, a system may select 108 a subset of diverse solutions from the set of initial solutions that will be preserved, with the non-diverse solutions being omitted. With a relatively small set of diverse solutions remaining, some embodiments may then use a straight forward (e.g., brute force) approach to test many variations of the remaining solutions in order to identify and improve 110 the selected diverse solutions. Once the remaining solutions have been improved 110, one or more of the improved final solutions may be presented to a user via an appropriate device and interface.

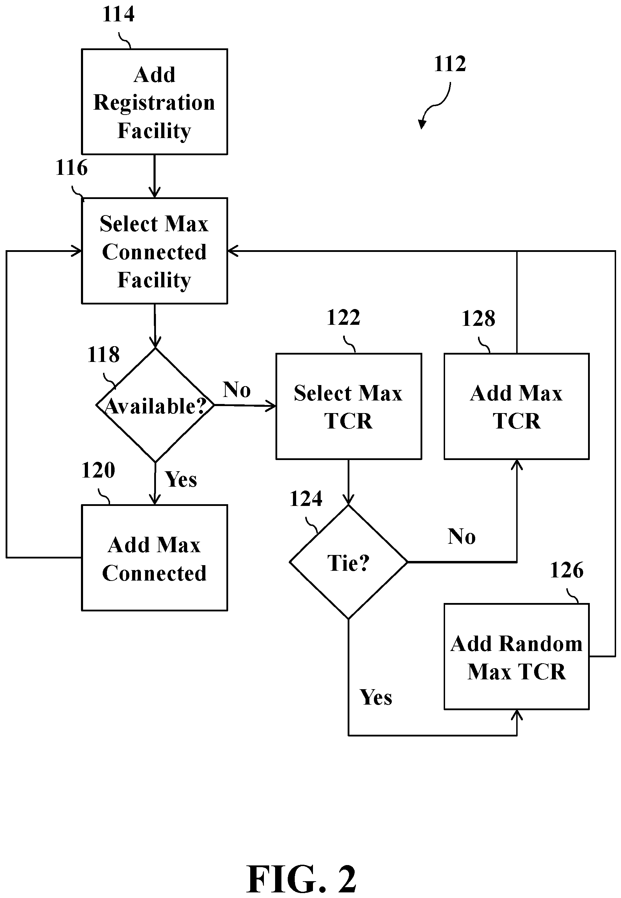

Turning now to FIG. 2, that figure shows a flowchart of an exemplary set of steps 112 that some embodiments may perform to sort facilities before placement, as part of generating 106 a set of initial solutions. Sorting may begin by adding 114 a registration facility at the top of a list of facilities. For the purposes of this step, a "registration facility" should be understood as referring to a facility where tubes arriving in the laboratory are registered with a laboratory information system (not shown) or are otherwise subjected to initial intake upon arrival. Next, some embodiments may select 116 from the remaining unsorted facilities the facility having the most connections to the most recently placed facility (e.g., in the first iteration, select 116 the facility having the most connections with the registration facility), where the number of connections can be determined using the flow collection that describes the flow of samples or personnel between each facility pair. If it is determined that a connected facility is available 118 (i.e., a facility with connection to the prior facility exists), that facility may be added 120 to the list just below the prior facility.

If it is determined that no connected facility is available 118 (e.g., where the previous facility that was placed has no direct traffic with any other facilities, which may be defined as a state in which no connected facility is available in some embodiments), some embodiments may instead select 122 a facility having the highest total closeness rating ("TCR"). In some embodiments, TCR may be determined using the traffic or flow collection, by summing the input and output of flows for each facility, and then selecting 122 the facility having the highest total traffic or TCR and adding 128 that facility to the list below the previously added facility. If there is a tie 124 between two facilities when selecting 122 based on TCR, some embodiments may randomly select and add 126 one of the facilities with tied TCR to the list below the previously added facility. Sorting the entire list of facilities in the above manner may be used to produce a list ordered by the priority that should be given to each facility during placement. For example, some embodiments may be configured to place the registration facility near the entrance 22 by giving that facility the highest priority. In some embodiments, next highest priority may go to the facility having the most connections with registration, or, the facility having the highest total input and output traffic or flow, which is also likely to be the facility that will have the highest impact on overall efficiency of method when placed optimally.

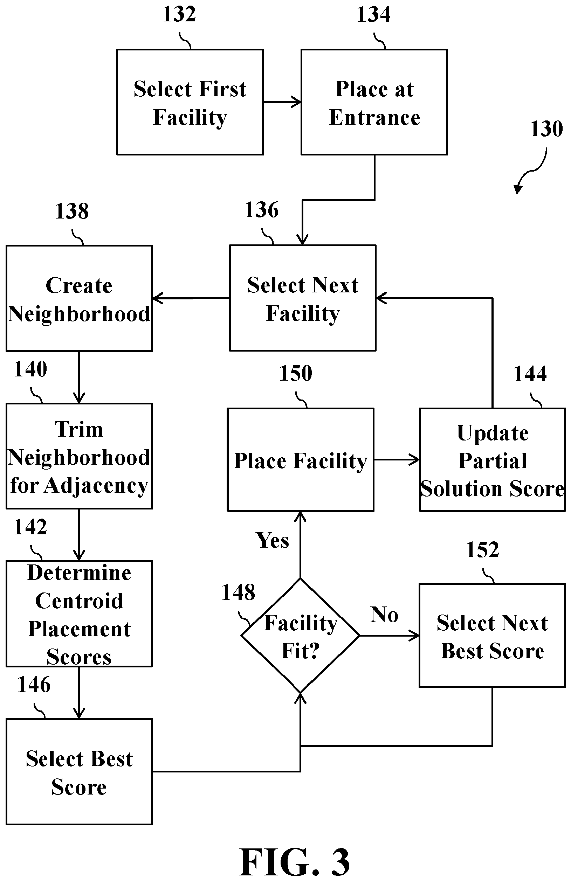

With a sorted list of facilities, some embodiments may begin to experiment with placing facilities in the laboratory area 10 in order to generate 106 a set of initial solutions, as shown in the exemplary set of steps 130 of FIG. 3. Using the sorted list of facilities, some embodiments may select 132 a first facility from the list (e.g., the registration facility) and place 134 it proximately to the entrance 22. Some embodiments may then select 136 the next facility from the sorted list and create 138 a neighborhood around the placed facilities. The neighborhood indicates the possible places that the centroid of the subsequent facility may be placed into. Depending upon the discipline of the facility being placed, the neighborhood may be trimmed 140 down to only those free areas 14 that will satisfy the adjacency constraints if the centroid of the facility being placed were to be located there. For each possible centroid placement within the neighborhood a score may be determined 142 using the objective equation or a similar equation, considering distance and flow between the facility currently being placed and those facilities already placed, with the lowest score indicating the best place to locate the centroid of the facility being placed.

Having identified the centroid placement location having the best score, that location may be selected 146 for placement, and some embodiments may verify 148 that the facility fits in that location, selecting the next best score 152 if it does not. If the facility does fit 148, some embodiments may place 150 the facility at the selected location, and update 144 the total score for the partial solution using the objective equation or a similar equation. With the score updated 144, the next facility may be selected 136 from the list, and the steps of FIG. 3 iterated until all facilities have been placed.

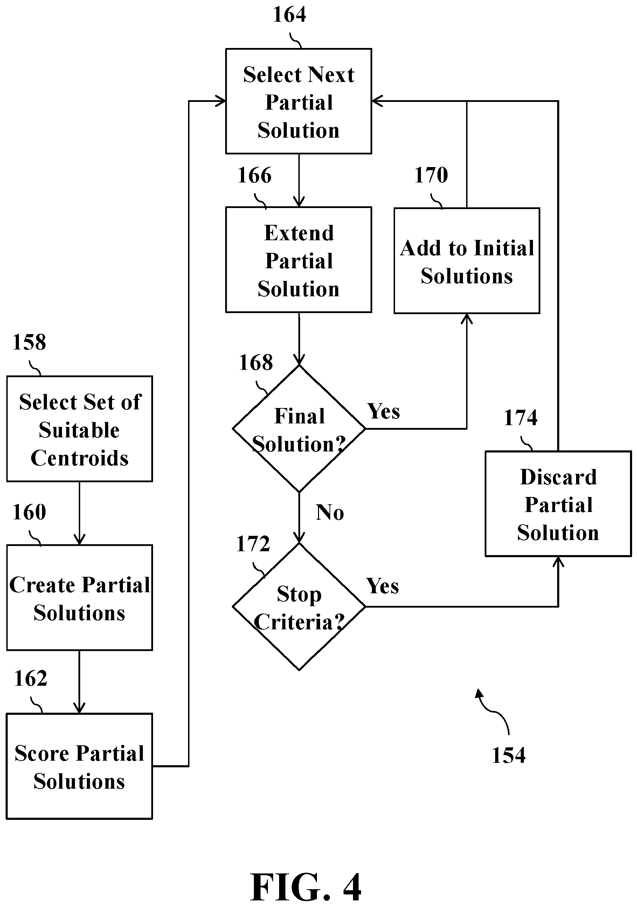

While the steps of FIG. 3 may produce a solution or small handful of solutions for the FLP, it is likely that more numerous, and more efficient solutions may be produced by tweaking the steps of FIG. 3. For example, FIG. 4 shows a flowchart of an exemplary set of steps 154 that some embodiments may perform to produce a set of initial solutions based upon a set of partial solutions by taking a more heuristic approach. The steps of FIG. 4 show a branch and bound method for generating a set of initial solutions from a set of partial solutions, and may be integrated with the steps of FIG. 3 by replacing several steps shown in that figure (i.e., 146, 148, 152, 150, and 144). Instead of placing a facility's centroid in the best scoring position within the neighborhood, a set of suitable centroid placement positions may be selected 158, far enough from one another to maintain diversity and to control combinatorial expansion of the tree of possibilities, and then, from all of these potential placements, partial solutions may be created 160. Different parameters may control the expansion of the partial solutions.

For example, this could include the number of possible places in the neighborhood from which the solution can be extended, the minimum distance between two selected possible points for the extension, and other parameters. Further, once a place is selected to locate the centroid in the partial solution, partial solutions may be generated with the centroid placed at that location both vertically and horizontally.

With a set of partial solutions created 160, some embodiments may then score 162 the partial solutions using the objective equation, and then iterate through the partial solutions by selecting 164 the next best scoring partial solution from the list, and extending 166 the partial solution (i.e., continuing down the path of the solution by placing additional facilities) until either a final solution is determined 168 that solves the FLP by placing all facilities and meeting all constraints, or a stop criteria is encountered 172. If a final solution is determined 168 from a partial solution, that partial solution will be considered an initial solution and will be added 170 to the initial solution list. If no final solution is determined 168 for a particular partial solution, it will eventually encounter 172 a stop criteria that will cause the branch of that partial solution to be trimmed, and the partial solution to be discarded 174. Stop criteria may include, for example, the score of the partial solution being worse than another existing solution that has more facilities placed, as this means that the extension 166 of the solution has traversed down an inefficient branch of the tree. Another stop criteria may include there not being enough available space to fit the facility being placed, as this indicates that the extension 166 of the solution has traversed down a branch of the tree that will not produce a final solution 168.

After a partial solution is determined to be a final solution 168, or a stop criteria is encountered 172, some embodiments may then select 164 the next best scoring partial solutions and the steps of FIG. 4 may be iterated through again until all partial solutions have been converted to initial solutions or discarded. As can be seen, the combined steps of FIGS. 3 and 4 may produce a larger set of initial solutions, while still providing a high level of confidence that the set of initial solutions will contain numerous efficient solutions.

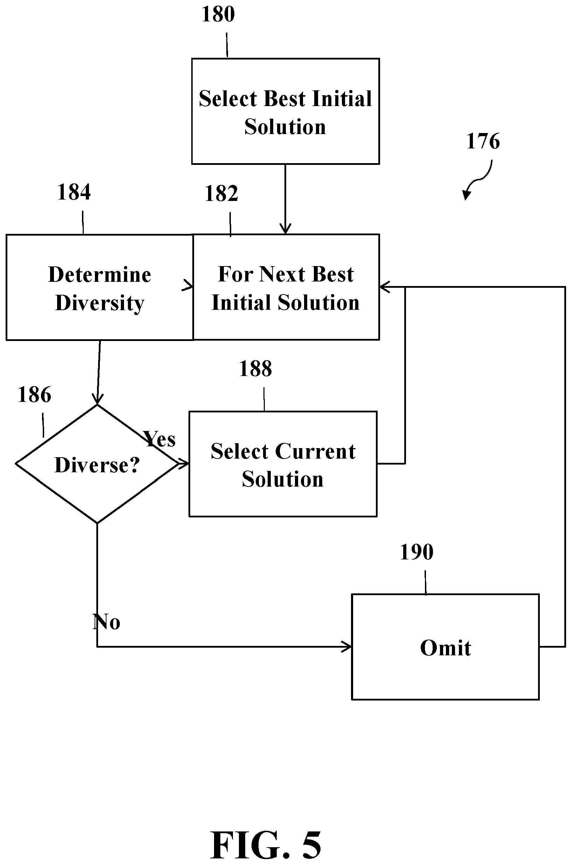

Turning now to FIG. 5, that figure shows a flowchart of an exemplary set of steps 176 that some embodiments may perform to select a set of diverse solutions from the set of initial solutions. As explained, proceeding with a subset of diverse solutions selected from the initial set of solutions allows for multiple solutions that may not be significantly different from each other to be reduced in number, in order to save on processing time and avoid repetitious activities that may not produce meaningfully superior results. The approach shown in FIG. 5 is to discard the similar solutions by comparing each initial solution using a diversity measure defined as the sum of distances between gravity centers of each discipline in two different solutions. This process may begin efficiently by first selecting 180 the best scoring initial solution, according to the objective equation, and then analyzing 182 the next best initial solution remaining in the list. The currently analyzed 182 next best solution then may have its diversity determined 184 using the above method or a similar method, and its diversity may be compared to all previously selected initial solutions. If the current initial solution is diverse 186 compared to those previously selected, it will be selected 188 to be included in the list of diverse solutions, and some embodiments may proceed by analyzing 182 the next best initial solution remaining in the list. If any initial solution is determined 186 to not be diverse compared to the previously selected solutions, it may be omitted 190 as an insignificant variation on those previous solutions.

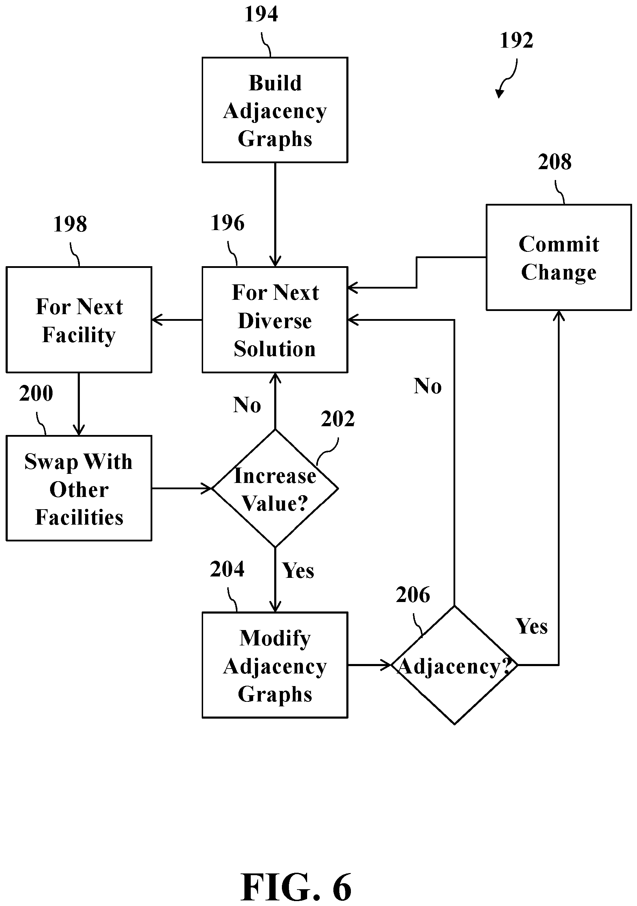

With a set of diverse solutions available, some embodiments may take a comparatively more straightforward approach to searching for and identifying small improvements to those diverse solutions that may result in more efficient solutions to the FLP. One exemplary approach could be to use a 2-opt optimization algorithm to swap placed facilities of equal size with each other, and determine whether the resulting solution is an acceptable improvement that produces a better score when applying the objective function to the new solution. Having reduced the set of initial solutions to a more manageable number of truly diverse solutions, this straightforward approach may not be unreasonable. For example, FIG. 6 is a flowchart of one exemplary set of steps 192 that some embodiments may perform to improve the selected set of diverse solutions. Before testing any changes to the diverse solutions, some embodiments may build 194 an adjacency graph or other collection for each of the set of diverse solutions. In order to maintain the adjacency constraint through numerous facility swaps without checking the neighborhood of every facility after each swap, a graph of adjacency may be built 194 and maintained. Each facility of a discipline is a node of this graph, and the adjacency between facilities is an edge between the two associated nodes. When switching two facilities from different disciplines in the laboratory area 10, the associated graphs may be easily modified. Fulfillment of the adjacency constraint among the facilities of a similar discipline may be verified through the simple task of checking to verify if the associated graph is still connected or not.

With the adjacency graph built 194, some embodiments may then iterate through each diverse solution 196 and, for each facility 198, swap that facility with other facilities having the same dimensions 200. If the swap does not result in an increased value 202 according to the objective equation, the swap may be reversed or discarded, and the next diverse solution may be proceeded to 196. If the swap does result in an increased value 202, the adjacency graph 204 must be modified to reflect the swapped facilities. If adjacency is maintained 206 after the modification 204, then the facility swap may be maintained or committed 208, and some embodiments may proceed to the next diverse solution 196. Once each diverse solution has been improved or tested for improvement in a manner such as that shown in FIG. 6, one or more of the diverse, improved solutions may be presented to a user, and used to implement the shown laboratory layout.

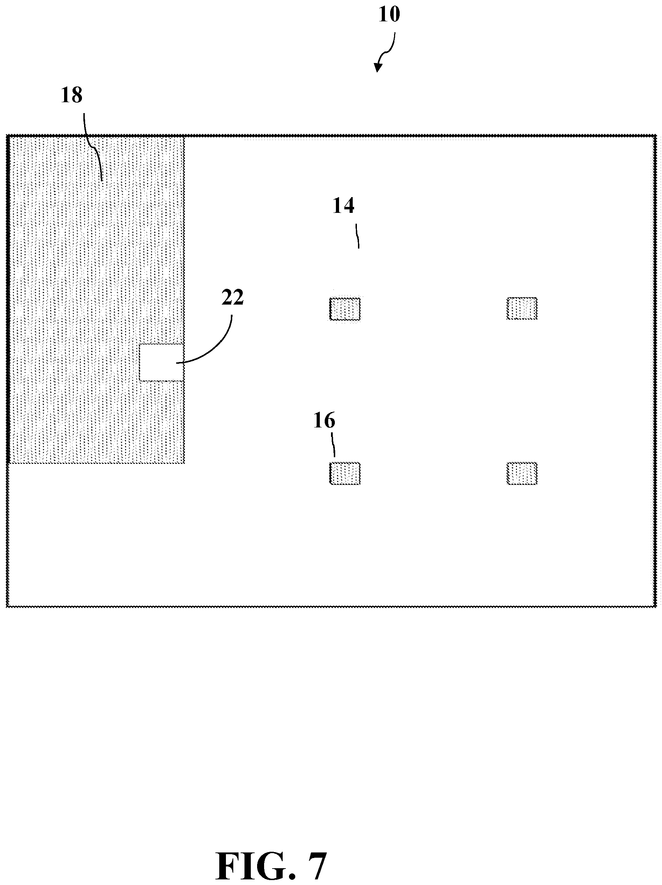

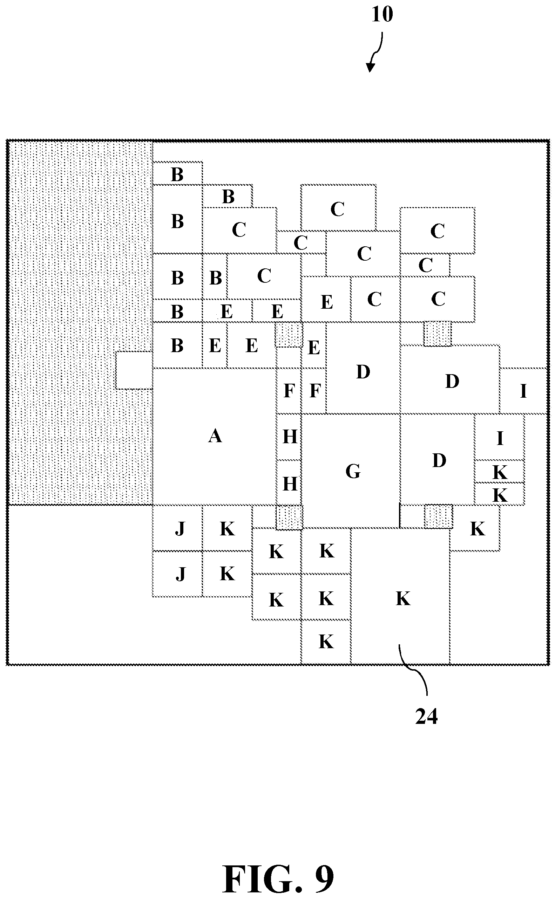

FIG. 9 shows a diagram of an exemplary layout such as could be produced in some embodiments using the steps of FIG. 1 on an initial laboratory layout of FIG. 7. In this example, the laboratory area 10 is about 300 square meters, and needs to accommodate forty-six facilities of varying dimensions, spread across eleven disciplines. The facilities and laboratory area have been discretized with a scale of one meter. As can be seen, the previously free area 14 within the laboratory area 10 has been largely filled with blocks representing the discretized dimensions of facilities 24 and their surrounding clearance areas. Each facility is marked with a letter indicating the discipline for that facility, and it can be seen that the adjacency constraint has been fulfilled throughout the solution such that each facility is adjacent to a facility having a shared discipline, and the registration facility, marked A, is located next to the entrance 22. In the near-optimal solution shown in FIG. 9, it can be seen that the proposed solution is comprised of densely packed facilities with little free area 14 remaining within the area occupied by facilities. Free space is also maintained at the edges of the dense layout, which could allow decision makers to expand corridors and clearances with minimal loss in relative placement quality for affected facilities.

It should be understood that any one or more of the teachings, expressions, embodiments, examples, etc. described herein may be combined with any one or more of the other teachings, expressions, embodiments, examples, etc. that are described herein. The following-described teachings, expressions, embodiments, examples, etc. should therefore not be viewed in isolation relative to each other. Various suitable ways in which the teachings herein may be combined will be readily apparent to those of ordinary skill in the art in view of the teachings herein. Such modifications and variations are intended to be included within the scope of the claims.

Having shown and described various embodiments of the present invention, further adaptations of the methods and systems described herein may be accomplished by appropriate modifications by one of ordinary skill in the art without departing from the scope of the present invention. Several of such potential modifications have been mentioned, and others will be apparent to those skilled in the art. For instance, the examples, embodiments, geometries, materials, dimensions, ratios, steps, and the like discussed above are illustrative and are not required. Accordingly, the scope of the present invention should be considered in terms of the following claims and is understood not to be limited to the details of structure and operation shown and described in the specification and drawings.

## Claims

1. A method of operating a computing device for generating an efficient laboratory layout, the method comprising:

   a) obtaining, with the computing device, a set of constraints pertaining to a set of facilities and a laboratory area, wherein the set of constraints comprises, for each facility, a dimension of the facility and a discipline, and wherein the laboratory area comprises a dimension, a set of free areas, and an entrance;
   b) obtaining, with the computing device, a flow collection that describes one or more flows of objects between facilities from the set of facilities;
   d) generating, with the computing device, a set of initial layouts for the facilities within the laboratory area based upon a set of partial layouts, the flow collection and the set of constraints (106); and
   identifying a set of diverse layouts (108) within the set of initial layouts for generating the efficient laboratory layout using a diversity measure algorithm of the computing device, wherein:

   a) each layout in the set of initial layouts comprises a set of discipline groups;
   b) a best initial layout (180), selected according to an objective equation, in the set of initial layouts is immediately added to the set of diverse layouts; and
   c) the diversity measure algorithm comprises, for each layout in the set of initial layouts, determining a sum of distances between gravity centers of each of the sets of discipline groups in that layout, and, where the sum of distances for that layout is substantially different from the sum of distances of each diverse layout in the set of diverse layouts, add that layout to the set of diverse layouts (186),

   wherein the layouts from the set of initial layouts, not identified as diverse layouts are omitted for generating the efficient laboratory layout.

2. The method of claim 1, wherein each diverse layout of the set of diverse layouts comprises a set of facility placements, the method further comprising the step of improving the set of diverse layouts by:

   a) building an adjacency graph for each diverse layout of the set of diverse layouts (194);
   b) for each facility placement of the set of facility placements for each diverse layout, swapping that facility placement with another facility placement of the same dimension to create a test layout (200);

c) modifying the adjacency graph for the test layout (204);

d) verifying that a discipline adjacency constraint is valid for the test layout using the adjacency graph; and

e) only where the score of the test layout improves relative to that diverse layout, and the adjacency constraint is valid for the test layout, replace that diverse layout with the test layout.

3. The method of claim 1, wherein the step of generating the set of initial layouts comprises sorting the set of facilities into a sorted facility list by:

a) adding a registration facility of the set of facilities at a first position of the sorted facility list (114); and

b) for each remaining facility of the set of facilities, repeating the steps of:

i) selecting, as a selected facility, a facility from the set of facilities that has the highest flow with a most recently added facility based upon the flow collection;

ii) where there is no facility sharing flow with the most recently added facility, selecting, as the selected facility, a facility from the set of facilities that has the highest total closeness rating, where total closeness rating can be determined as the sum of input flow and output flow for the facility based upon the flow collection; and

iii) adding the selected facility to a next position in the sorted facility list (120).

4. The method of claim 3, wherein the step of generating the set of initial layouts comprises placing the facilities by:

a) selecting the registration facility from the first position of the sorted list (132) and placing it by an entrance of the laboratory (134);

b) for each remaining facility of the sorted facility list, repeating the steps of:

i) selecting that facility from the sorted facility list (136);

ii) creating the set of partial layouts based on a set of possible placements for that facility;

iii) scoring each of the set of partial layouts using an objective equation;

iv) using a branch and bound algorithm, extending each of the set of partial layouts until either a final layout is reached for that partial layout, or one or more stop criteria are satisfied for that partial layout; and

v) only where the final layout is reached, adding that partial layout to the set of initial layouts.

5. The method of claim 4, wherein the one or more stop criteria comprises:

a) a first criteria satisfied when a score for that partial layout is worse than a score for a second partial layout of the set of partial layouts, wherein the second partial layout has more of the set of facilities placed than that partial layout; and

b) a second criteria satisfied when placement of a subsequent facility is impossible.

6. The method of claim 4, wherein the set of possible placement for that facility comprises both a facility placement location and a facility placement orientation, and wherein the facility placement orientation consists of a vertical orientation and a horizontal orientation.

7. The method of claim 1, wherein each of the set of facilities and the laboratory area are rectangular and discretized to a scale measurement.

8. A system comprising one or more computers configured by computer executable instructions stored on a non-transitory computer readable medium to perform the method as claimed in any of the preceding claims 1 to 7.

**Patentansprüche**

1. Ein Verfahren zum Betreiben einer rechnergestützten Vorrichtung zum Generieren eines effizienten Laborlayouts, wobei das Verfahren aufweist:

a) Erhalten, mit der rechnergestützten Vorrichtung, eines Sets von Bedingungen, die sich auf ein Set von Einrichtungen und einen Laborbereich beziehen, wobei das Set von Bedingungen für jede Einrichtung eine Dimension der Einrichtung und eine Disziplin aufweist, und wobei der Laborbereich eine Dimension, ein Set von freien Bereichen und einen Eingang aufweist;

b) Erhalten, mit der rechnergestützten Vorrichtung, eine Flusssammlung, die einen oder mehrere Flüsse von Objekten zwischen Einrichtungen aus dem Set von Einrichtungen beschreibt;

d) Generieren, mit der rechnergestützten Vorrichtung, eines Sets von initialen Layouts für die Einrichtungen innerhalb des Laborbereichs, basierend auf einem Set von partiellen Layouts, der Flusssammlung und dem Set von Bedingungen (106); und

Identifizieren eines Sets von diversen Layouts (108) innerhalb des Sets von initialen Layouts zum Generieren des effizienten Laborlayouts unter Verwendung eines Diversitätsmessalgorithmus der rechnergestützten Vorrichtung, wobei:

a) jedes Layout in dem Set von initialen Layouts ein Set von Disziplingruppen aufweist;
b) ein bestes initiales Layout (180), das gemäß einer objektiven Gleichung ausgewählt wird, in dem Set von initialen Layouts unmittelbar zu dem Set von diversen Layouts hinzugefügt wird; und
c) der Diversitätsmessalgorithmus weist für jedes Layout in dem Set von initialen Layouts das Bestimmen einer Summe von Distanzen zwischen Gravitationszentren jedes der Sets von Disziplingruppen in diesem Layout auf, und, wenn die Summe von Distanzen für dieses Layout sich wesentlich von der Summe von Distanzen jedes diversen Layouts in dem Set von diversen Layouts unterscheidet, Hinzufügen dieses Layouts zu dem Set von diversen Layouts (186),

wobei die Layouts von dem Set von initialen Layouts, die nicht als diverse Layouts identifiziert werden, zum Generieren des effizienten Laborlayouts weggelassen werden.

2. Das Verfahren gemäß Anspruch 1, wobei jedes diverse Layout von dem Set von diversen Layouts ein Set von Einrichtungsplatzierungen aufweist, wobei das Verfahren ferner den Schritt aufweist Verbessern des Sets von diversen Layouts durch:

a) Aufbau eines Adjazenzgraphen für jedes diverse Layout des Sets diverser Layouts (194);
b) für jede Einrichtungsplatzierung des Sets von Einrichtungsplatzierungen für jedes diverse Layout, Vertauschen dieser Einrichtungsplatzierung mit einer anderen Einrichtungsplatzierung der gleichen Dimension, um ein Testlayout (200) zu erzeugen;
c) Modifizieren des Adjazenzgraphen für das Testlayout (204);
d) Überprüfen, ob eine Disziplin-Adjazenz-Bedingung für das Testlayout gültig ist, unter Verwendung des Adjazenzgraphen; und
e) nur dann, wenn sich die Punktzahl des Testlayouts relativ zu dem diversen Layout verbessert und die Adjazenzbedingung für das Testlayout gültig ist, Ersetzen des diversen Layouts durch das Testlayout.

3. Das Verfahren nach Anspruch 1, wobei der Schritt des Generierens des Sets von initialen Layouts das Sortieren des Sets von Einrichtungen in eine sortierte Einrichtungsliste aufweist durch:

a) Hinzufügen einer Registrierungseinrichtung des Sets von Einrichtungen an einer ersten Position der sortierten Einrichtungsliste (114); und
b) für jede verbleibende Einrichtung des Sets von Einrichtungen, Wiederholen der folgenden Schritte:

i) Auswählen als eine ausgewählte Einrichtung eine Einrichtung aus dem Set von Einrichtungen, die den höchsten Fluss mit einer zuletzt hinzugefügten Einrichtung aufweist, basierend auf der Flusssammlung;
ii) wenn es keine Einrichtung gibt, die den Fluss mit der zuletzt hinzugefügten Einrichtung teilt,
Auswählen als die ausgewählte Einrichtung eine Einrichtung aus dem Set von Einrichtungen, die die höchste Gesamtnähebewertung aufweist, wobei die Gesamtnähebewertung bestimmt werden kann als die Summe von Eingangsfluss und Ausgangsfluss für die Einrichtung basierend auf der Flusssammlung; und
iii) Hinzufügen der ausgewählten Einrichtung zu einer nächsten Position in der sortierten Einrichtungsliste (120).

4. Das Verfahren nach Anspruch 3, wobei der Schritt des Generierens des Sets von initialen Layouts das Platzieren der Einrichtungen aufweist durch:

a) Auswählen der Registrierungseinrichtung aus der ersten Position der sortierten Liste (132) und Platzieren dieser Einrichtung an einem Eingang des Labors (134);
b) für jede verbleibende Einrichtung der sortierten Einrichtungsliste, Wiederholen der Schritte von:

i) Auswahl dieser Einrichtung aus der sortierten Einrichtungsliste (136);
ii) Erstellen des Sets von partiellen Layouts basierend auf einem Set von möglichen Platzierungen für diese Einrichtung;
iii) Bewerten jedes der Sets von partiellen Layouts unter Verwendung einer objektiven Gleichung;
iv) Verwenden eines Verzweigungs- und Begrenzungsalgorithmus, Ausdehnen jedes des Sets von partiellen Layouts, bis entweder ein finales Layout für dieses partielle Layout erreicht ist oder ein oder mehrere Stoppkriterien für dieses partielle Layout erfüllt sind; und

v) nur wenn das finale Layout erreicht ist, Hinzufügen dieses partiellen Layouts zum Set der initialen Layouts.

5. Das Verfahren nach Anspruch 4, wobei das eine oder die mehreren Stoppkriterien aufweisen:

a) ein erstes Kriterium, das erfüllt ist, wenn eine Punktzahl für dieses partielle Layout schlechter ist als eine Punktzahl für ein zweites partielles Layout aus dem Set von partiellen Layouts ist, wobei das zweite partielle Layout mehr von dem Set von Einrichtungen platziert aufweist als dieses partielle Layout; und
b) ein zweites Kriterium erfüllt ist, wenn die Platzierung einer nachfolgenden Einrichtung unmöglich ist.

6. Das Verfahren nach Anspruch 4, wobei das Set der möglichen Platzierungen für diese Einrichtung sowohl einen Standort der Einrichtungsplatzierung als auch eine Ausrichtung der Einrichtungsplatzierung aufweist, und wobei die Ausrichtung der Einrichtungsplatzierung aus einer vertikalen Ausrichtung und einer horizontalen Ausrichtung besteht.

7. Das Verfahren nach Anspruch 1, wobei jedes der Sets von Einrichtungen und der Laborbereich rechteckig und auf ein Skalenmaß diskretisiert sind.

8. Ein System, das einen oder mehrere Computer aufweist, welche mittels computerausführbarer Instruktionen konfiguriert sind, die auf einem nichttransitorischen, computerlesbaren Medium gespeichert sind, das Verfahren nach einem der vorhergehenden Ansprüche 1 bis 7 durchzuführen.

## Revendications

1. Procédé de fonctionnement d'un dispositif informatique pour générer un agencement de laboratoire efficace, le procédé comprenant de :

a) obtenir, avec le dispositif informatique, un ensemble de contraintes se rapportant à un ensemble d'installations et une zone de laboratoire, dans lequel l'ensemble de contraintes comprend, pour chaque installation, une dimension de l'installation et une discipline, et dans lequel la zone de laboratoire comprend une dimension, un ensemble de zones libres et une entrée ;
b) obtenir, avec le dispositif de informatique, une collection de flux qui décrit un ou plusieurs flux d'objets entre des installations parmi l'ensemble d'installations ;
d) générer, avec le dispositif informatique, un ensemble d'agencements initiaux pour les installations à l'intérieur de la zone de laboratoire sur la base d'un ensemble d'agencements partiels, de la collection de flux et de l'ensemble de contraintes (106) ; et
identifier un ensemble d'agencements divers (108) à parmi l'ensemble d'agencements initiaux pour générer l'agencement de laboratoire efficace en utilisant un algorithme de mesure de diversité du dispositif informatique, dans lequel :

a) chaque agencement de l'ensemble d'agencements initiaux comprend un ensemble de groupes de disciplines ;
b) un meilleur agencement initial (180), choisi en fonction d'une équation d'objectif, de l'ensemble d'agencements initiaux est immédiatement ajouté à l'ensemble d'agencements divers ; et
c) l'algorithme de mesure de diversité comprend, pour chaque agencement de l'ensemble d'agencements initiaux, de déterminer une somme de distances entre des centres de gravité de chacun des ensembles de groupes de disciplines de cet agencement et, lorsque la somme de distances pour cet agencement est sensiblement différente de la somme de distances pour chaque agencement divers de l'ensemble d'agencements divers, ajouter cet agencement à l'ensemble d'agencements divers (186),

dans lequel les agencements parmi l'ensemble d'agencements initiaux, non identifiés comme des agencements divers sont omis pour générer l'agencement de laboratoire efficace.

2. Procédé selon la revendication 1, dans lequel chaque agencement divers de l'ensemble d'agencements divers comprend un ensemble d'implantation d'installation, le procédé comprenant en outre l'étape consistant à améliorer l'ensemble d'agencements divers par :

a) construire un graphe de contiguïté pour chaque agencement divers de l'ensemble d'agencements divers (194) ;
b) pour chaque implantation d'installation de l'ensemble d'implantations d'installation pour chaque agencement divers, permuter cette implantation d'installation avec une autre implantation d'installation de la même dimension pour créer un agencement de test (200) ;
c) modifier le graphe de contiguïté pour l'agencement de test (204) ;
d) vérifier qu'une contrainte de contiguïté de discipline est valide pour l'agencement de test en utilisant le graphe de contiguïté ; et

e) uniquement lorsque le score de l'agencement de test s'améliore par rapport à cet agencement divers, et que la contrainte de contiguïté est valide pour l'agencement de test, remplacer cet agencement divers par l'agencement de test.

3. Procédé selon la revendication 1, dans lequel l'étape consistant à générer l'ensemble d'agencements initiaux comprend de trier l'ensemble d'installations dans une liste d'installations triée par :

a) ajouter une installation d'enregistrement de l'ensemble d'installations à une première position de la liste d'installations triée (114) ; et
b) pour chaque installation restante de l'ensemble d'installations, répéter les étapes consistant à :

i) sélectionner, en tant qu'installation sélectionnée, une installation parmi l'ensemble d'installations qui a le flux le plus élevé avec une installation la plus récemment ajoutée sur la base de la collection de flux ;
ii) lorsqu'il n'y a aucune installation partageant un flux avec l'installation la plus récemment ajoutée, sélectionner, en tant qu'installation sélectionnée, une installation parmi l'ensemble d'installations qui a l'estimation de proximité totale la plus élevée, dans laquelle l'estimation de proximité totale peut être déterminé comme la somme de flux d'entrée et de flux de sortie pour l'installation sur la base de la collection de flux ; et
iii) ajouter l'installation sélectionnée à une position suivante dans la liste d'installations triée (120).

4. Procédé selon la revendication 3, dans lequel l'étape consistant à générer l'ensemble d'agencements initiaux comprend d'implanter les installations par :

a) sélectionner l'installation d'enregistrement de la première position de la liste triée (132) et implanter celle-ci par une entrée du laboratoire (134) ;
b) pour chaque installation restante de la liste d'installations triée, répéter les étapes consistant à :

i) sélectionner cette installation parmi la liste d'installations triée (136) ;
ii) créer l'ensemble d'agencements partiels sur la base d'un ensemble d'implantations possibles pour cette installation ;
iii) noter chaque agencement de l'ensemble d'agencements partiels en utilisant une équation d'objectif ;

iv) en utilisant un algorithme de séparation et d'évaluation, étendre chaque agencement de l'ensemble d'agencements partiels jusqu'à ce que soit un agencement final soit atteint pour cet agencement partiel, soit un ou plusieurs critères d'arrêt soient satisfaits pour cet agencement partiel ; et
v) uniquement lorsque l'agencement final est atteint, ajouter cet agencement partiel à l'ensemble d'agencements initiaux.

5. Procédé selon la revendication 4, dans lequel le ou les critères d'arrêt comprennent :

a) un premier critère satisfait lorsqu'un score pour cet agencement partiel est plus mauvais qu'un score pour un second agencement partiel de l'ensemble d'agencements partiels, dans lequel le second agencement partiel a plus de l'ensemble d'installations implanté que cet agencement partiel ; et
b) un second critère satisfait lorsqu'une implantation d'une installation subséquente est impossible.

6. Procédé selon la revendication 4, dans lequel l'ensemble d'implantations possibles pour cet agencement comprend à la fois un lieu d'implantation d'installation et une orientation d'implantation d'installation, et dans lequel l'orientation d'implantation d'installation consiste en une orientation verticale et une orientation horizontale.

7. Procédé selon la revendication 1, dans lequel chaque installation de l'ensemble d'installations et la zone de laboratoire sont rectangulaires et discrétisées à une mesure d'échelle.

8. Système comprenant un ou plusieurs ordinateurs configurés par des instructions exécutables par ordinateur stockées sur un support lisible par ordinateur non transitoire pour mettre en œuvre le procédé selon l'une quelconque des revendications 1 à 7 précédentes.

100 ⟶

**102**

┌─────────────────┐
│   Determine     │
│   Laboratory    │
│   Dimensions    │
└─────────────────┘

**104**

┌─────────────────┐
│   Determine     │
│    Facility     │
│ Characteristics │
└─────────────────┘

**106**

┌─────────────────┐
│    Generate     │
│     Initial     │
│    Solutions    │
└─────────────────┘

**108**

┌─────────────────┐
│  Select Diverse │
│    Solutions    │
└─────────────────┘

**110**

┌─────────────────┐
│     Improve     │
│    Selected     │
│    Solutions    │
└─────────────────┘

# FIG. 1

114

**Add Registration Facility**

112

116

**Select Max Connected Facility**

118

**Available?**

122

**Select Max TCR**

128

**Add Max TCR**

No

120

Yes

**Add Max Connected**

124

**Tie?**

No

126

Yes

**Add Random Max TCR**

**FIG. 2**

**FIG. 3**

**FIG. 4**

**180**

Select Best Initial
Solution

**176**

**184**

**182**

Determine
Diversity

For Next Best
Initial Solution

**188**

**186**

Diverse?

Yes

Select Current
Solution

No

**190**

Omit

# FIG. 5

194

**Build Adjacency Graphs**

192

208

**Commit Change**

198

196

**For Next Facility**

**For Next Diverse Solution**

200

No

202

**Swap With Other Facilities**

**Increase Value?**

No

204

Yes

206

Yes

**Modify Adjacency Graphs**

**Adjacency?**

# FIG. 6

**FIG. 7**

**FIG. 8**

**FIG. 9**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **C. ABDELAHAD et al.** *A mixed integer programming formulation for solving operating theatre layout problem: A multi-goal approach*

- **S. P. SINGH et al.** *A review of different approaches to the facility layout problems*